Europäisches Patentamt

(19) European Patent Office

Office européen des brevets

(11) Publication number : **0 450 968 A2**

## (12) EUROPEAN PATENT APPLICATION

(21) Application number : **91303006.0**

(22) Date of filing : **05.04.91**

(51) Int. Cl.⁵ : **H05K 1/03, H01L 23/373**

A request for correction of the description and claim 3 has been filed pursuant to Rule 88 EPC. A decision on the request will be taken during the proceedings before the Examining Division (Guidelines for Examination in the EPO, A-V, 2.2).

(30) Priority : **06.04.90 GB 9007895**
**26.11.90 GB 9025657**

(43) Date of publication of application :
**09.10.91 Bulletin 91/41**

(84) Designated Contracting States :
**BE CH DE FR GB IT LI NL SE**

(71) Applicant : **DE BEERS INDUSTRIAL DIAMOND DIVISION (PROPRIETARY) LIMITED**
**43 Main Street**
**Johannesburg Transvaal (ZA)**

(72) Inventor : **Jones, Barbara Lynn**
**80 Chisbury Close**
**Forest Park Bracknell RG12 3TX (GB)**

(74) Representative : **Jones, Alan John et al**
**CARPMAELS & RANSFORD 43 Bloomsbury Square**
**London, WC1A 2RA (GB)**

(54) **Circuit boards.**

(57)   A circuit board comprises a sheet (10) which is characterised by a surface (12) carrying electrical circuitry (14) and a layer (18) behind the surface (12) and in heat-conducting communication with it. The layer (18) comprises a mass of diamond or cubic boron nitride particles in a polymeric, metallic or ceramic matrix. The concentration of diamond or cubic boron nitride in the matrix is typically 30 to 60 percent by weight.

EP 0 450 968 A2

Jouve, 18, rue Saint-Denis, 75001 PARIS

$FIG.$ 1

$FIG.$ 2

## BACKGROUND TO THE INVENTION

This invention relates to circuit boards.

Substrates for mounting electronics are used in a wide variety of electronic apparatus, e.g. surface mount packages, printed circuit boards etc. Such substrates consist of an electrical circuit formed in the surface of a board which typically consists of several layers. Some of these layers are made of a material or form which conduct heat rapidly away from the surface carrying the circuit. This is necessary because heat is generated in a circuit during use and this heat can be detrimental to the functioning of the circuit or of the electronic device or equipment which utilises the circuit.

## SUMMARY OF THE INVENTION

According to the present invention, there is provided a circuit board comprising a self-supporting sheet comprising:

(i) a surface carrying electrical circuitry or an element thereof; and

(ii) a zone behind the surface and in heat-conducting communication with it which comprises a mass of diamond or cubic boron nitride particles in a matrix selected from polymeric, metallic and ceramic, the concentration of the particles in the matrix not exceeding 60 percent by weight.

## DESCRIPTION OF THE DRAWINGS

Figure 1 illustrates a plan view of an embodiment of the invention;

Figure 2 is a section along the line 2-2 of Figure 1; and

Figure 3 is a sectional side view of a second embodiment of the invention.

## DESCRIPTION OF EMBODIMENTS

The circuit board may be one which carries electrical circuitry on a surface thereof. The circuitry may be printed on the surface or may form part of an integrated chip. The board may also be one which carries an element of such circuitry.

When the matrix is polymeric, it is preferably thermoplastic in nature and may be selected from phenolics, modified phenolics, melamines, polyamides, polyamide-imides, polycarbonates, polysulphanes, acrylonitriles, styrene plastics and olefin polymers.

When the matrix is metallic it may be selected from copper, nickel, molybdenum, aluminium and stainless steel.

When the matrix is ceramic it may be selected from alumina, aluminium nitride, silicon carbide, silicon oxide, silicon nitride, and beryllium oxide. Where the particles are diamond particles and the ceramic matrix is an oxide, it is preferable that the diamond particles be protected by a suitable coating such as a refractory metal or an oxygenfree ceramic.

The particles of the zone may be diamond or cubic boron nitride. The particles are preferably diamond because of the superior heat conductivity property of diamond. The particles will be more than 2 microns in size. The maximum size of the particles used is dictated by the width or depth of the zone.

The particles are present in the zone in an amount not exceeding 60 percent by weight. The particle content of the zone will preferably be in the range 10 to 60 percent by weight and more preferably 30 to 60 percent by weight.

The zone will generally be in the form of a layer. One surface of the layer may form the surface which carries the electrical circuitry or element thereof. Alternatively, this layer can be located below this surface and spaced from it by a layer of polymer of the type described above or metal. The two layers will be bonded together.

The sheet is self-supporting in the sense that it can carry the circuitry or element thereof without buckling or bending to any significant extent. The sheet may be rigid or have a certain degree of fexibility.

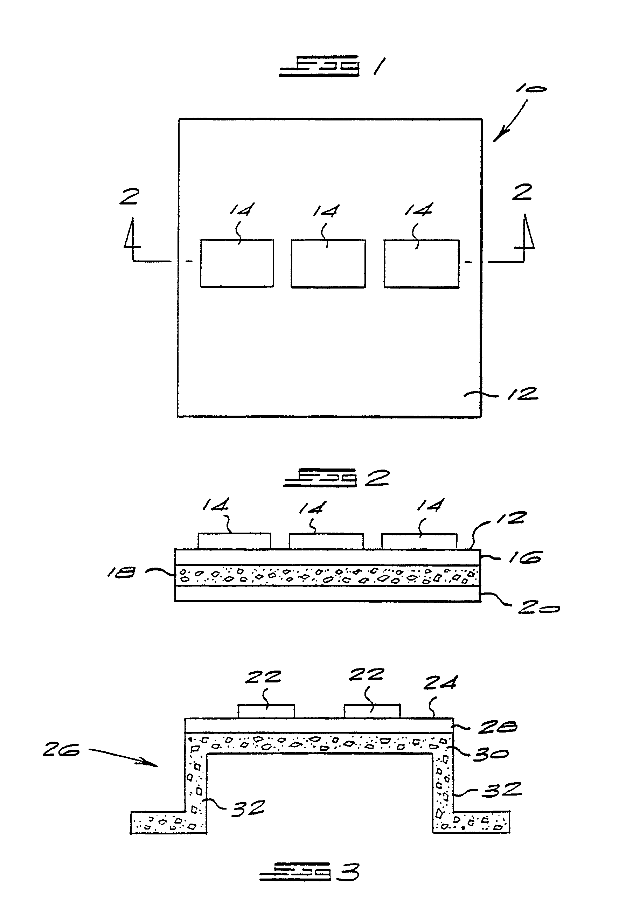

Embodiments of the invention will now be described with reference to the accompanying drawings. Referring to Figures 1 and 2, there is shown a circuit board comprising a rectangular sheet 10 having a major upper surface 12 on which is mounted a plurality of integrated chips 14.

The sheet 10 comprises three layers 16, 18 and 20 bonded together. The layer 16 is made of a material such as a polymer or metal. The layer 18 comprises a mass of diamond particles in a matrix of the type described above and the layer 20 is made of an insulating or other material. In use, heat generated in the integrated chips passes into the layer 16 and then into the layer 18 from whence it is rapidly conducted away by virtue of the presence of the highly heat conductive diamond particles in this layer.

Figure 3 illustrates a second embodiment. In this embodiment, the integrated chips 22 are carried on the surface 24 of a sheet 26. The sheet 26 comprises an insulating layer 28 and a second layer 30 bonded thereto. The layer 30 has downwardly depending fins 32 and comprises a mass of diamond particles in a matrix of the type described above. The funs assist in dissipating heat entering the layer 30.

The matrix is preferably polymeric as this reduces the weight of the circuit board. The presence of diamond particles in the range specified above increases the thermal conductivity of the material 2 to 4 times compared with that of the base polymer.

In an example of the invention, a circuit board was produced by placing a mixture of diamond particles and a powdered modified phenolic polymer in a mould. The mixture was heated to 60°C and then heated further under the influence of pressure to 175°C. This caused the polymer to melt. The contents of the mould were allowed to cool and the moulded product then removed from the mould.

A rectangular sheet was recovered from the mould. This sheet was selfsupporting and capable of carrying electrical circuitry or an element thereof.

Using this method sheets were produced with diamond particles in the range 20 to 200 microns and concentrations of diamond ranging from 12 to 50 percent by weight.

In order to produce a sheet having a polymer layer between the diamond-containing layer and the surface for carrying the electrical circuitry, a green state mixture of diamond and polymer may first be produced in a mould and then a further layer of diamond-free polymer powder placed on the green state product. The whole is then heated to melt the polymer and form the sheet.

A diamond/metal layer for a circuit board of the invention may be made by making a mixture of the diamond particles and the metal in powdered form, causing a thin layer of this mixture to be deposited on to a support surface, compacting the layer and heat treating the compacted layer under conditions which will not lead to degradation of the diamond particles. Generally, a slurry of the diamond/metal mixture in water will be made, this slurry deposited on the support surface and a major part of the water removed from the slurry before the compaction step. These steps are generally described in European Patent Publication No. 0 294 198.

## Claims

1. A circuit board comprising a self-supporting sheet (10) comprising:

    (i) a surface (12) carrying electrical circuitry (14) or an element thereof; and

    (ii) a zone (18) behind the surface (12) and in heat- conducting communication with it which comprises a mass of diamond or cubic boron nitride particles in a matrix selected from polymeric, metallic and ceramic, the concentration of the particles in the matrix not exceeding 60 percent by weight.

2. A circuit board according to claim 1 wherein the polymeric matrix is a thermoplastic polymer.

3. A circuit board according to claim 2 wherein the thermoplastic polymer is selected from phenolics, modified phenolics, melamines, polyamides, polyamide-imides, polycarbonates, polysulphanes, acrylonitriles, styrene plastics and olefin polymers.

4. A circuit board according to claim 1 wherein the matrix is a metallic matrix selected from copper, nickel, molybdenum, aluminium and stainless steel.

5. A circuit board according to claim 1 wherein the matrix is a ceramic matrix and is selected from alumina, aluminium nitride, silicon carbide, silicon oxide, silicon nitride, and beryllium oxide.

6. A circuit board according to any one of the preceding claims wherein the concentration of particles is in the range 10 to 60 percent by weight.

7. A circuit board according to any one of the preceding claims wherein the concentration of particles is in the range 30 to 60 percent by weight.

8. A circuit board according to any one of the preceding claims wherein a layer of a polymeric material ( 16) is provided between the zone ( 18) and the surface ( 12).

9. A circuit board according to claim 8 wherein the zone (18) comprises a layer which is bonded to the polymeric layer (16).

FIG 1

10

2

14    14    14

2

12

FIG 2

14    14    14    12

16

18

20

22    22    24

26

28

30

32

32

FIG 3